Europäisches Patentamt

European Patent Office

Office européen des brevets

(11) Veröffentlichungsnummer: **0 281 733 B1**

(19)

## (12) EUROPÄISCHE PATENTSCHRIFT

(45) Veröffentlichungstag der Patentschrift: **08.04.92**

(51) Int. Cl.5: **G01R 33/06**

(21) Anmeldenummer: **88100796.7**

(22) Anmeldetag: **20.01.88**

(54) **Frequenzanaloger Magnetfeldsensor.**

(30) Priorität: **02.02.87 DE 3703001**

(43) Veröffentlichungstag der Anmeldung:
**14.09.88 Patentblatt 88/37**

(45) Bekanntmachung des Hinweises auf die
Patenterteilung:
**08.04.92 Patentblatt 92/15**

(84) Benannte Vertragsstaaten:
**AT BE CH DE FR GB IT LI NL SE**

(56) Entgegenhaltungen:
**EP-A- 0 111 698**
**DE-A- 2 822 509**
**US-A- 4 091 335**

**SENSORS AND ACTUATORS, Band 7, Nr. 3,
Juli 1985, Seiten 189-198, Elsevier Sequoia,
Lausanne, CH; A.R. COOPER et al.:
"Electronic processing of transducer signals: Hall effect as an example"**

(73) Patentinhaber: **SIEMENS AKTIENGESELL-
SCHAFT**
**Wittelsbacherplatz 2**
**W-8000 München 2(DE)**

(72) Erfinder: **Hölzlein, Karlheinz, Dr.**
**St. Georgstrasse 45**
**W-8552 Höchstadt(DE)**

**Beschreibung**

Die Erfindung bezieht sich auf einen Magnetfeldsensor gemäß dem Oberbegriff des Anspruchs 1.

Ein solcher Magnetfeldsensor ist aus der EP-A-0 111 698 bekannt.

Zum Messen eines Magnetfeldes sind insbesondere Halbleiter-Bauelemente geeignet, deren elektrische Eigenschaften infolge galvanomagnetischer Effekte durch ein Magnetfeld verändert werden. Zu diesen Magnetfeldsensoren zählen auch die sogenannten Magnetotransistoren.

In "IEEE Electron Device Letters, Bd. EDL-3, No. 8, August 1982, S. 203 - 205," sind laterale bipolare Magnetotransistoren offenbart, deren Emittern jeweils zwei Kollektoren zugeordnet sind. In einer Ausführungsform befindet sich der Emitter zwischen den beiden Kollektoren. Mit dieser Anordnung kann ein parallel zur Substratoberfläche angelegtes Magnetfeld mit einer Komponente parallel zur Symmetrieebene des Magnetotransistors gemessen werden. Durch die Lorentz-Ablenkung der vom Emitter vertikal, d.h. senkrecht zur Halbleiter-Oberfläche in den Halbleiter injizierten Ladungsträger wird ein parallel zur Halbleiter-Oberfläche verlaufendes Hall-Feld verursacht. Dieses Hall-Feld bewirkt eine Modulation der Emitter-Basis-Spannung entlang der parallel zur Oberfläche im Substrat verlaufenden Grenzfläche des Emitters zur Basis und somit eine Modulation der Anzahl der in die Basis injizierten Ladungsträger. Die Basis ist mit zwei Basiskontakten versehen, die derart einander gegenüber angeordnet sind, daß sich der Emitter und die beiden Kollektoren dazwischen befinden. Bei gegebener Basis-Emitter-Spannung ist bei Anwesenheit eines Magnetfeldes der zu den beiden Kollektoren fließende Strom unterschiedlich groß. Zwischen den beiden Kollektoren kann dann eine Spannungsdifferenz gemessen werden, deren Betrag von der Magnetfeldstärke abhängt. Eine weitere Ausführungsform betrifft einen Magnetotransistor, dessen magnetfeldempfindliche Achse senkrecht zur Halbleiteroberfläche orientiert ist. In diesem Fall sind die beiden Kollektoren neben einer Längsseite des Emitters angeordnet und der überwiegende Beitrag zum Kollektorstrom wird durch laterale Injektion verursacht. Auch in diesem Fall wird durch die auf die injizierten Ladungsträger wirkende Lorentzkraft ein unterschiedlicher Kollektorstrom verursacht. Magnetfeldsensoren mit diesen Gestaltungsmerkmalen haben eine etwa um den Faktor 1000 höhere Empfindlichkeit als Hall-Generatoren gleicher geometrischer Abmessungen.

Aus der EP-A-0 099 979 ist weiterhin ein lateraler bipolarer Magnetotransistor bekannt, dessen Emitterschicht ohne Zwischenräume in beispielsweise drei parallele Unterschichten aufgeteilt ist. Die mittlere Unterschicht besteht aus einem stark dotierten Material vom gleichen Leitfähigkeits-Typ wie die Basisschicht. Alle drei Unterschichten sind zur Kontaktierung mit einer gemeinsamen Metallelektrode verbunden. Bei dieser Anordnung fließt ein Teil des Basisstromes als reiner Leckstrom und leistet somit keinen Beitrag zum Strom, der vom Emitter in die Basis injiziert wird. Dadurch wird der Emitter-Wirkungsgrad gesenkt und die Relativstromempfindlichkeit des Magnetotransistors gegen einen Magnetotransistor mit herkömmlichem Emitter gesteigert.

Die in den beiden letzgenannten Druckschriften offenbarten Magnetotransistoren liefern ein analoges Ausgangssignal, beispielsweise eine Differenzspannung oder einen Differenzstrom zwischen den beiden Kollektoren bzw. den beiden Emitter-Kollektorstrecken.

In der modernen Meßtechnik sind jedoch insbesondere Sensoren vorteilhaft, die ein frequenzanaloges Ausgangssignal bereitstellen. Frequenzsignale sind sowohl hinsichtlich der Übertragung weniger störanfällig als auch ohne nachfolgende Analog-Digital-Wandlung zur Weiterverarbeitung mittels digitaler Elektronik und Mikroprozessoren geeignet. Zur Erzeugung eines frequenzanalogen Ausgangssignales muß bei diesen Magnetfeldsensoren die analoge Meßgröße in einem vom Sensor getrennten Spannungs- bzw. Strom-Frequenzwandler umgewandelt werden. Eine derartige Vorrichtung ist beispielsweise in der deutschen Offenlegungsschrift 2 822 509 offenbart, bei der eine zu messende nichtelektrische Analoggröße in eine analoge Spannung umgewandelt wird, die mittels einer aus einer ungeraden Anzahl von $I^2$L-Invertern aufgebauten frei schwingenden Ringoszillatorschaltung in ein Frequenzsignal übergeführt wird. Die Schwingungsfrequenz dieser Oszillatorschaltung ist der an ihrer Stromeingangsklemme über einen Widerstand anliegenden Spannung proportional. Eine zu messende nichtelektrische Analoggröße, beispielsweise eine Temperatur, muß somit zunächst in einem außerhalb der Oszillatorschaltung befindlichen Schaltungsteil, beispielsweise einer Spannungsteilerschaltung, die einen Thermistor als temperaturempfindliches Bauteil enthält, in eine analoge Spannung umgewandelt werden. Sensorelement und Oszillatorschaltung sind in diesem Beispiel voneinander getrennt und bilden zwei unabhängige Einheiten.

Der Erfindung liegt nun die Aufgabe zugrunde, einen empfindlichen integrierten Magnetfeldsensor mit frequenzanalogem Ausgang anzugeben, bei dem die Sensorelemente und die Elemente der Oszillatorschaltung eine Einheit bilden.

Die genannte Aufgabe wird erfindungsgemäß gelöst mit den Merkmalen des Anspruchs 1. Ein Magnetfeld parallel zur magnetfeldempfindlichen Achse der Magnetotransistoren be wirkt eine Änderung des vom Emitter zum Kollektor fließenden Stromes. Dadurch wird der Injektionsstrom, der in den dieser Emitter-Kollektor-Strecke zugeordneten Schalttransistor eingespeist wird, verändert. Dies bewirkt eine Veränderung der Gatterlaufzeit der mit diesen Magnetotransistoren aufgebauten Inverter und somit eine Frequenzänderung eines aus diesen Invertern zusammengesetzten Oszillators. Bei einem Magnetfeldsensor mit diesen Gestaltungsmerkmalen ist die durch den Einsatz von Magnetotransistoren ermöglichte hohe Magnetfeldempfindlichkeit verknüpft mit platzsparender bipolarer I²L-Technik in einem für die Digitaltechnik kompatiblen digitalen Sensor mit frequenzanalogem Ausgang. Der Zusammenhang zwischen Magnetfeld und Frequenzsignal am Ausgang des Magnetfeldsensors ist im Bereich kleiner Magnetfelder linear. Dabei müssen die in die Schalttransistoren fließenden Injektionsströme stets in einem Größenordnungsbereich liegen, innerhalb dem eine indirekte Proportionalität zwischen Gatterlaufzeit und Injektionsstrom gilt.

In der bevorzugten Ausführungsform nach Anspruch 2 sind Magnetotransistoren mit Doppelkollektoren vorgesehen, bei denen ein Magnetfeld mit einer Richtungskomponente, die geeignet ist über die Lorentzkraft eine Asymmetrie der vom Emitter zu den ersten und zweiten Kollektoren des Magnetotransistors fließenden Ströme zu erzeugen, eine Differenz zwischen den in die beiden Schalttransistoren eingespeisten Ströme verursacht wird. Die zu unterschiedlichen Magnetotransistoren gehörenden Inverter sind jeweils zu einem Oszillator zusammengefaßt, so daß zwei Oszillatoren gebildet werden. Die zu einem Magnetotransistor gehörenden ersten und zweiten Inverter haben entsprechend der Differenz der Injektionsströme unterschiedliche Gatterlaufzeiten und die beiden Oszillatoren schwingen mit unterschiedlicher Frequenz, deren Differenz proportional zum Magnetfeld ist.

Als Oszillatoren sind wegen ihres einfachen Aufbaus insbesondere Ringoszillatoren geeignet. Da zum Meßsignal zwei baugleiche Oszillatoren beitragen, die im gleichen Fertigungsverfahren hergestellt und auf dem Chip benachbart sind, werden störende Umgebungseinflüsse, wie z.B. Temperatur, die sich in einer Nullpunktdrift der Frequenz eines einzelnen Oszillators bemerkbar machen würden, weitgehend reduziert. Außerdem wird durch die Differenzbildung der Wertebereich, in dem zwischen Ausgangssignal und Magnetfeld eine lineare Beziehung besteht, erweitert.

In den bevorzugten Ausführungsformen gemäß den Unteransprüchen 4 bis 6 ist der Flächenbedarf des Magnetfeldsensors auf der Chip-Oberfläche in vorteilhafter Weise verringert.

Die Doppelkollektor-Anordnung mit zwischen den Kollektoren befindlichem Emitter ist eine besonders bevorzugte Ausgestaltung des Magnetotransistors mit hoher Magnetfeldempfindlichkeit. Die Empfindlichkeit kann noch durch die Einlagerung einer Zone mit inverser Dotierung in die Emitter-Wanne gesteigert werden. Durch die damit verbundene zusätzliche vertikale Stromkomponente wird das entlang der Emitter-Basis-Grenzfläche herrschende Hall-Feld verstärkt und die Asymmetrie der vom Emitter in die Basis zu den beiden Kollektoren injizierten Stromkomponenten erhöht.

Zur weiteren Erläuterung der Erfindung wird auf die Zeichnung verwiesen, in deren

Figur 1    der erfindungsgemäße Magnetfeldsensor in einem Prinzipschaltbild erläutert ist. In

Figur 2    ist der Magnetfeldsensor in einer Draufsicht schematisch veranschaulicht.

Figur 3    zeigt zwei Inverterstufen des Magnetfeldsensors schematisch im Schnitt und in

Figur 4    ist eine vorteilhafte Ausgestaltung der Ausgangs-Inverterstufen der Ringoszillatoren im Schnitt dargestellt und

Figur 5    zeigt eine bevorzugte Ausführungsform des Emitters eines Magnetotransistors ebenfalls im Schnitt.

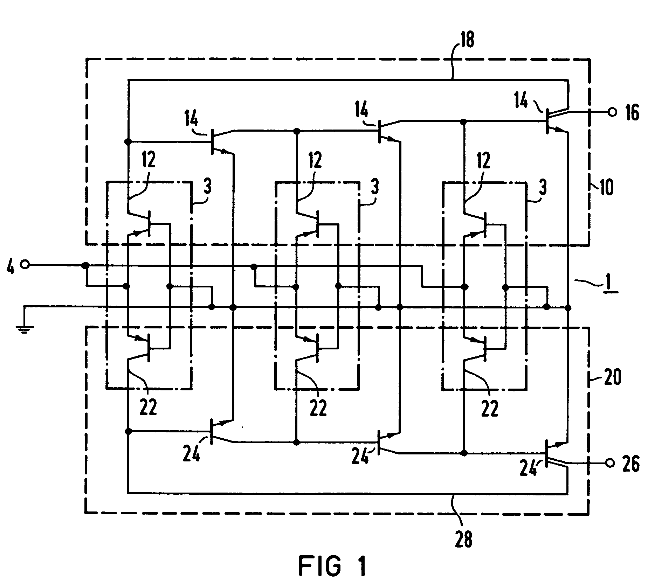

Gemäß Figur 1 enthält ein Magnetfeldsensor 1 eine ungerade Anzahl von Magnetotransistoren 3, die im Prinzipschaltbild der Figur zur Erläuterung jeweils als zwei voneinander getrennte Transistoren veranschaulicht sind. Die Magnetotransistoren 3 sind jeweils mit ihrem Emitter 32 und ihrer Basis 34 in einer Strom- bzw. Spannungsversorgung 4 elektrisch verbunden. Die Magnetotransistoren 3 enthalten jeweils einen ersten und zweiten Kollektor 12 bzw. 22. Bei den Magnetotransistoren 3 handelt es sich um einachsige Bauelemente, die beispielsweise nur auf die Richtungskomponente des magnetischen Feldes ansprechen, die parallel zur Oberfläche und zur Symmetrieebene des Magnetotransistors 3 liegt. Den Magnetotransistoren 3 sind jeweils ein erster und ein zweiter Schalttransistor 14 bzw. 24 zugeordnet. Der erste und zweite Kollektor 12 bzw. 22 eines jeden Magnetotransistors 3 ist jeweils mit der Basis des ihm zugeordneten ersten bzw. zweiten Schalttransistors 14 bzw. 24 verbunden. Die Magnetotransistoren 3 bilden als stromeinspeisende Transistoren mit den ihnen zugeordneten Schalttransistoren 14 und 24 jeweils einen ersten bzw. zweiten Inverter. Bei diesen Invertern handelt es sich in der bevorzugten Ausführungsform entsprechend der Figur um Inverter aus der I²L-(integrierte Injektionslogik-) Familie, die in integrierter Form besonders platzsparend zu realisieren sind. Diese ersten und zweiten Inverter sind im Beispiel der Figur 1 jeweils zu einem ersten bzw. zweiten Ringoszillator 10 bzw. 20 zusammengefaßt, indem jeder Kollektor der ersten und zweiten Schalttransistoren 14 bzw. 24 mit der Basis eines anderen ersten bzw. zweiten Schalttransistors 14 bzw. 24 verbunden ist. Jeweils einer der ersten und zweiten Schalttran sistoren 14 bzw. 24 ist mit einem Doppelkollektoranschluß versehen, von denen jeweils ein Anschluß den frequenzanalogen Ausgang 16 und 26 des ersten bzw. zweiten Ringoszillators 10 bzw. 20 bildet. Der andere Anschluß ist über die Rückkopplungsleitung 18 bzw. 28 mit der Basis eines ersten bzw. zweiten Schaltransistors 14 bzw. 24 verbunden. Die Magnetotransistoren 3 sind im Magnetfeldsensor 1 derart in einer Reihe angeordnet, daß sie hinsichtlich ihres inneren Aufbaus mittels einfacher Linearverschiebungen auseinander hervorgehen. Dadurch ergibt sich für die ersten und zweiten Kollektoren 12 bzw. 22 jeweils eine annähernd gleiche geometrische Anordnung relativ zum Emitter 32 des betreffenden Magnetotransistors 3 bezüglich einer durch ein äußeres homogenes Magnetfeld vorgegebenen Richtung.

Die Gatterlaufzeit eines I$^2$L-Inverters hängt vom Betrag des Injektionsstromes ab und für kleine Injektionsströme ergibt sich eine indirekte Proportionalität. Die Gatterlaufzeit und die Anzahl der zu einem Ringoszillator zusammengefaßten Inverter bestimmt ihrerseits die Schwingungsfrequenz des Ringoszillators. Bei Anwesenheit eines Magnetfeldes mit vorbestimmten, zum Nachweis geeigneten Richtungskomponenten relativ zum Magnetfeldsensor 1 ergibt sich eine Asymmetrie zwischen den zum ersten bzw. zweiten Kollektor 12 bzw. 22 des Magnetotransistors 3 fließenden Injektionsströmen. Aufgrund der damit verbundenen unterschiedlichen Gatterlaufzeiten für die ersten und zweiten Inverter schwingen die beiden Ringoszillatoren 10 und 20 mit unterschiedlicher Frequenz und die Frequenzdifferenz kann zur Ermittlung der wirksamen Magnetfeldstärke herangezogen werden.

In einer weiteren Ausführungsform können auch Magnetotransistoren mit einem einzigen Kollektor, wie sie beispielsweise aus "IEEE Electron Device Letters, Vol. EDL-4, No. 3, März 1983, S. 51 - 53" bekannt sind, als stromeinspeisende Transistoren für I$^2$L-Inverter verwendet werden. Anstelle von beispielsweise drei Magnetotransistoren mit Doppelkollektoren kann der Magnetfeldsensor dann sechs Einfachkollektor-Magnetotransistoren enthalten, deren magnetfeldempfindliche Achsen parallel zueinander verlaufen, die aber hinsichtlich des Vorzeichens ihrer Magnetfeldempfindlichkeit zwei Gruppen bilden. Jeweils drei dieser Magnetotransistoren haben dann hinsichtlich ihres inneren Aufbaus und ihrer Lage im Magnetfeldsensor gemeinsam, daß sie durch einfache Translationen wenigstens annähernd zur Deckung gebracht werden können. Die Magnetotransistoren der einen Gruppe sind zu den Magnetotransistoren der anderen Gruppe bis auf lineare Verschiebungen wenigstens annähernd spiegelsymmetrisch aufgebaut. Die zu den Gruppen gehörenden Oszillatoren unterscheiden sich bei angelegtem Magnetfeld dann ebenfalls in ihrer Schwingungsfrequenz.

In einer vereinfachten Ausführungsform kann ein Magnetfeldsensor auch einen einzigen magnetfeldempfindlichen Oszillator, beispielsweise ein Ringoszillator mit drei Einfachkollektor-Magnetotransistoren als stromeinspeisende Transistoren für I$^2$L-Inverter, enthalten. Dadurch wird zwar die Anzahl der Magnetotransistoren verringert, jedoch ist es dann unter Umständen zur Kompensation von Umgebungseinflüssen erforderlich, im Magnetfeldsensor einen weiteren annähernd baugleichen magnetfeldunempfindlichen Oszillator anzuordnen.

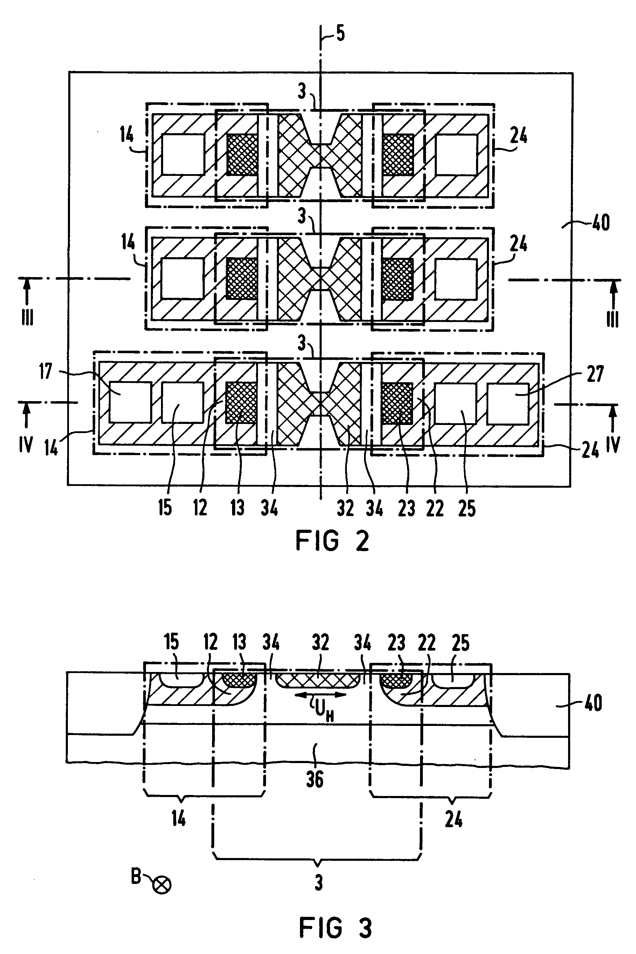

Entsprechend Figur 2 sind die Magnetotransistoren 3 in einem Silizium-Substrat als laterale pnp-Transistoren ausgebildet. Aus Gründen der Übersichtlichkeit sind in der Figur Leiterbahnen, Kontakte und Passivierungsschichten nicht dargestellt. In seinem zentralen Bereich enthält ein Magnetotransistor 3 einen p$^+$-dotierten Emitter 32, dem ein erster und zweiter p-Kollektor 12 bzw. 22 mit ihren p$^+$-dotierten Kollektorkonta ten 13 bzw. 23 zugeordnet sind. Die Kollektoren 12 und 22 sind zueinander spiegelbildlich in einer senkrecht zur Halbleiter-Oberfläche stehenden Symmetrieebene des Emitters 32 angeordnet. Im Beispiel der Figur steht diese Symmetrieebene senkrecht zur Zeichenebene. Die Kollektoren 12 und 22 werden in einer bevorzugten Ausführungsform zur Seite hin von einem Oxidwall 40 und in das Innere des Halbleiters hinein von einer n-dotierten Basis 34 begrenzt, die sich in den zwischen Emitter 32 und den Kollektoren 12 und 22 liegenden Bereichen bis an die Oberfläche des Halbleiters erstreckt. Die ersten und zweiten Kollektoren 12 bzw. 22 sind noch mit einer invers dotierten Wanne versehen, die als Kollektoren 15 und 25 eines ersten bzw. zweiten Schalttransistors 14 bzw. 24 dienen.

Die ersten und zweiten Kollektoren 12 und 22 sind zugleich das Basisgebiet für den als Vertikaltransistor ausgebildeten ersten bzw. zweiten Schalttransistor 14 bzw. 24. Die Basis 34 des lateralen Magnetotransistors 3 bildet zugleich den gemeinsamen Emitter der beiden einem Magnetotransistor 3 jeweils zugeordneten Schalttransistoren 14 und 24. Die Schalttransistoren jeweils einer Inverterstufe sind mit einem zusätzlichen Kollektor 17 bzw. 27 versehen. Die Magnetotransistoren 3 sind derart anzuordnen, daß ihre magnetfeldempfindlichen Achsen 5 wenigstens annähernd parallel zueinander orientiert sind. Im Ausführungsbeispiel der Figur bilden die magnetfeldempfindlichen Achsen 5 eine gemeinsame Symmetrieachse des Magnetfeldsensors. Die einzelnen Inverterstufen sind in einer bevorzugten Ausführungsform mittels eines Oxidwalls 40 voneinander isoliert. Durch diese Maßnahme wird die Schaltgeschwindigkeit und die Magnetfeldempfindlichkeit erhöht und eine unerwünschte Emitterinjektion parallel zum Magnetfeld unterdrückt. Als Halbleiter-Substrat ist insbesondere auch Galliumarsenid GaAs geeignet.

In Figur 3 ist die Struktur der von einem Magnetotransistor 3 mit den zwei Schalttransistoren 14 und 24 gebildeten Inverter stufen im Schnitt verdeutlicht. An die Basis 34 schließt großflächig ein $n^+$-dotierter Basiskontakt 36 an, der beispielsweise die Rückseite des aktiven Halbleiter-Bauelementes bildet. Der laterale Magnetotransistor 3 ist zum Messen magnetischer Felder B mit einer Komponente senkrecht zur Zeichenebene bzw. parallel zu der Symmetrieebene des Emitters 32 geeignet, die zugleich Spiegelebene der zueinander spiegelbildlich angeordneten Kollektoren 12 und 22 ist. Im Beispiel der Figur wird bei einem in die Zeichenebene hinein gerichteten Magnetfeld B durch die Stromkomponente senkrecht zur Halbleiteroberfläche eine Hall-Spannung $U_H$ parallel zum Boden der Wanne des Emitters 32 erzeugt. Dadurch wird die Emitter-Basis-Spannung moduliert und eine Asymmetrie des Emitter-Kollektor-Stromes erzeugt. Somit unterscheiden sich die in die jeweilige Basis des ersten und zweiten Schalttransistors 14 bzw. 24 eingespeisten Ströme und ebenso die entsprechenden Schaltzeiten der ersten und zweiten Inverter.

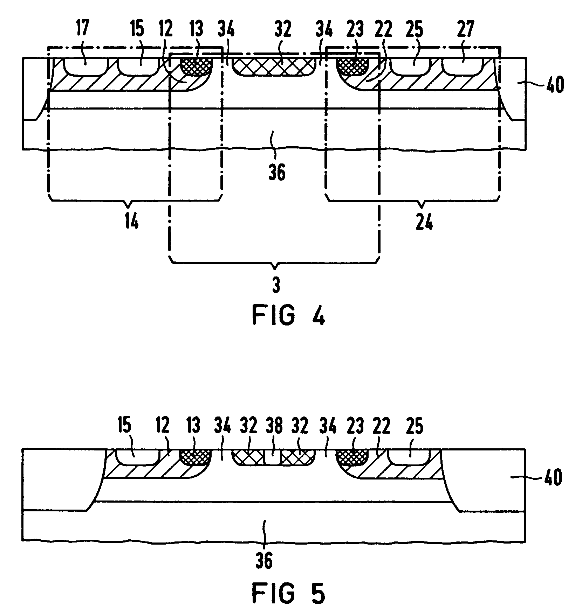

Die Doppelkollektor-Struktur eines der Schalttransistoren wird entsprechend Figur 4 durch zwei wannenförmige in die Kollek toren 12 und 22 des Magnetotransistors 3 eindiffundierte invers dotierte Kollektoren 17 und 27 gebildet.

Gemäß Figur 5 sind in einer besonders vorteilhaften Ausführungsform die Emitter 32 der Magnetotransistoren 3 in ihrem zentralen Bereich mit einer Zone 38 inverser Dotierung versehen, die sowohl an die Oberfläche des Substrates als auch an die unter dem Emitter 32 liegende Basis 34 angrenzt. Im Falle eines pnp-Magnetotransistors ist die Zone 38 $n^+$-dotiert und somit vom gleichen Leitfähigkeitstyp wie die Basis 34. In weiteren Ausführungsformen können auch mehrere derartige $n^+$-dotierte Zonen 38 in die Emitter 32 eingelagert sein. Die Zone 38 und der Emitter 32 sind mit einem gemeinsamen Anschluß versehen, der in der Figur nicht dargestellt ist. Da der Emitter 32 gegen den Basiskontakt 36 positiv vorgespannt ist, wird eine zusätzliche Stromkomponente erzeugt, die zwar keinen Beitrag zum Strom liefert, der in die Emitter-Kollektorstrecke des Magnetotransistors injiziert wird, jedoch bei Anwesenheit eines horizontalen Magnetfeldes senkrecht zur Zeichenebene zu einer zusätzlichen Verstärkung des parallel zum Wannenboden des Emitters 32 herrschenden Hallfeldes führt. Dadurch wird die Modulation der Emitter-Basis-Spannung entlang der parallel zur Oberfläche verlaufenden Emitter-Basis-Grenzfläche erhöht und die Frequenzdifferenz der am Ausgang der beiden Ringoszillatoren anstehenden frequenzanalogen Signale vergrößert.

## Patentansprüche

1. Magnetfeldsensor mit folgenden Merkmalen:
   a) Es sind mehrere bipolare Magnetotransistoren (3) mit wenigstens jeweils einem Kollektor (12, 22) und einer magnetfeldempfindlichen Achse (5) vorgesehen,
   b) diese Magnetotransistoren (3) sind bezüglich ihrer magnetfeldempfindlichen Achsen (5) wenigstens annähernd parallel zueinander angeordnet,
   c) den Kollektoren (12, 22) der Magnetotransistoren (3) ist jeweils ein Transistor zugeordnet,
   **gekennzeichnet** durch folgende weitere Merkmale:
   d) als Transistoren sind Schalttransistoren (14, 24) vorgesehen,
   e) diese Schalttransistoren (14, 24) bilden mit den ihnen zugeordneten Magnetotransistoren (3) jeweils einen Inverter,
   f) diese Inverter sind zu wenigstens einem Oszillator (10, 20) zusammengefaßt.

2. Magnetfeldsensor nach Anspruch 1, **gekennzeichnet** durch folgende Merkmale:
   a) die Magnetotransistoren (3) sind jeweils mit einem ersten (12) und einem zweiten Kollektor (22) versehen,
   b) dem ersten und dem zweiten Kollektor (12 bzw. 22) eines jeden Magnetotransistors (3) ist jeweils ein erster bzw. zweiter Schalttransistor (14 bzw. 24) zugeordnet,
   c) jeder Magnetotransistor (3) bildet als stromeinspeisender Transistor mit dem ersten und zweiten Schalttransistor (14, 24) einen ersten bzw. zweiten Inverter,
   d) die ersten und zweiten Inverter sind zu einem ersten bzw. zweiten Oszillator (10 bzw. 20) zusammengefaßt.

3. Magnetfeldsensor nach Anspruch 1 oder 2, **dadurch gekennzeichnet,** daß als Oszillatoren Ringoszillatoren (10 bzw. 20) vorgesehen sind.

4. Magnetfeldsensor nach einem der Ansprüche 1 bis 3, **dadurch gekennzeichnet,** daß die Kollektoren (12, 22) des Magnetotransistors (3) zugleich die Basis der ihnen zugeordneten Schalttransistoren (14, 24) bilden.

5.  Magnetfeldsensor nach Anspruch 4, **dadurch gekennzeinet,** daß die einem Magnetotransistor zugeordneten Schalttransistoren (14, 24) einen gemeinsamen Emitter haben, der zugleich die Basis (34) des Magnetotransistors (3) ist.

6.  Magnetfeldsensor nach einem der Ansprüche 1 bis 5, **dadurch gekennzeichnet,** daß der Magnetotransistor (3) als Lateral-Transistor und die Schalttransistoren (14, 24) als Vertikal-Transistoren ausgebildet sind.

7.  Magnetfeldsensor nach einem der Ansprüche 1 bis 6, **gekennzeichnet** durch folgende Merkmale:
    a) die Kollektoren (12, 22) des Magnetotransistors (3) sind spiegelbildlich zu einer senkrecht zur Halbleiter-Oberfläche stehenden Symmetrieebene des Emitters (32) des Magnetotransistors (3) angeordnet,
    b) der Emitter (32) ist zwischen den Kollektoren (12, 22) angeordnet.

8.  Magnetfeldsensor nach einem der Ansprüche 1 bis 7, **dadurch gekennzeichnet,** daß der Emitter (32) des Magnetotransistors (3) wenigstens eine Zone (38) mit inverser Dotierung enthält.

9.  Magnetfeldsensor nach einem der Ansprüche 1 bis 8, **dadurch gekennzeinet,** daß Gallium-Arsenid als Halbleiter-Substrat vorgesehen ist.

10. Magnetfeldsensor nach einem der Ansprüche 1 bis 8, **dadurch gekennzeichnet,** daß Silizium als Halbleiter-Substrat vorgesehen ist.

11. Magnetfeldsensor nach Anspruch 10, **dadurch gekennzeinet,** daß die zu verschiedenen Magnetotransistoren (3) gehörenden Inverter voneinander durch einen Oxidwall (40) getrennt sind.

**Claims**

1.  Magnetic field sensor having the following features:
    a) several bipolar magneto-transistors (3) are provided, having respectively at least one collector (12, 22) and a magnetic field-sensitive axis (5);
    b) these magneto-transistors (3) are arranged at least substantially parallel to each other relative to their magnetic field-sensitive axes (5),
    c) a respective transistor is associated with the collectors (12, 22) of the magnetotransistors (3),
    characterised by the following further features:
    d) switching transistors (14, 24) are provided as transistors,
    e) these switching transistors (14, 24) with the magneto-transistors (3) associated with them in each case form an inverter,
    f) these inverters are combined to form at least one oscillator (10, 20).

2.  Magnetic field sensor according to claim 1, characterised by the following features:
    a) the magneto-transistors (3) are, in each case, provided with a first (12) and a second collector (22),
    b) a first and second switching transistor (14 and 24 respectively) is associated, in each case, with the first and the second collector (12 and 22 respectively) of each magnetotransistor (3),
    c) each magneto-transistor (3) forms, as a current-feeding transistor with the first and second switching transistor (14, 24), a first and second inverter respectively,
    d) the first and second inverters are combined to form a first and second oscillator (10 and 20 respectively).

3.  Magnetic field sensor according to claim 1 or 2, characterised in that ring oscillators (10 and 20) are provided as oscillators.

4.  Magnetic field sensor according to one of the claims 1 to 3, characterised in that the collectors (12, 22) of the magneto-transistor (3) at the same time form the base of the switching transistors (14, 24) associated with them.

5.  Magnetic field sensor according to claim 4, characterised in that the switching transistors (14, 24) associated with a magneto-transistor have a common emitter which at the same time is the base (34) of the magneto-transistor (3).

6.  Magnetic field sensor according to one of the claims 1 to 5, characterised in that the magnetotransistor (3) is formed as a lateral transistor and the switching transistors (14, 24) are formed as vertical transistors.

7.  Magnetic field sensor according to one of the claims 1 to 6, characterised by the following features:

a) the collectors (12, 22) of the magnetotransistor (3) are arranged so as to be mirror-inverted in relation to a plane of symmetry of the emitter (32) of the magnetotransistor (3), which plane is perpendicular to the semiconductor surface,

b) the emitter (32) is arranged between the collectors (12, 22).

8.  Magnetic field sensor according to one of the claims 1 to 7, characterised in that the emitter (32) of the magneto-transistor (3) contains at least one zone (38) with inverse doping.

9.  Magnetic field sensor according to one of the claims 1 to 8, characterised in that gallium arsenide is provided as a semiconductor substrate.

10. Magnetic field sensor according to one of the claims 1 to 8, characterised in that silicon is provided as a semiconductor substrate.

11. Magnetic field sensor according to claim 10, characterised in that the inverters pertaining to various magneto-transistors (3) are separated from each other by means of an oxide wall (40).

**Revendications**

1.  Capteur de champ magnétique présentant les caractéristiques suivantes :

    a) il est prévu plusieurs magnétotransistors bipolaires (3) possédant respectivement au moins un collecteur (12,22) et un axe (5) sensible au champ magnétique,

    b) ces magnétotransistors (3) ont des axes (5) sensibles au champ magnétique qui sont au moins approximativement parallèles entre eux,

    c) respectivement un transistor est associé aux collecteurs (12,22) des magnétotransistors (3),

    caractérisé par les particularités suivantes :

    d) il est prévu, comme transistors, des transistors de commutation (14,24),

    e) ces transistors de commutation (14,24) forment respectivement un inverseur, avec les magnétotransistors (3) qui leur sont associés,

    f) ces inverseurs sont réunis pour former au moins un oscillateur (10,20).

2.  Capteur de champ magnétique suivant la revendication 1, caractérisé par les particularités suivantes :

    a) les magnétotransistors (3) comportent respectivement un premier collecteur (12) et un second collecteur (22),

b) respectivement un premier et un second transistor de com

mutation (14 et 24) est associé au premier et au second collecteur (12 et 22) de chaque magnétotransistor (3),

c) chaque magnétotransistor (3) forme, en tant que transistor d'injection de courant, avec des premier et second transistors de commutation (14,24), des premier et second inverseurs,

d) des premier et second inverseurs sont réunis pour former des premier et second oscillateurs (10 et 20).

3.  Capteur de champ magnétique suivant la revendication 1 ou 2, caractérisé par le fait qu'il est prévu comme oscillateurs, des oscillateurs en anneau (10 et 20).

4.  Capteur de champ magnétique suivant la revendication 1 à 3, caractérisé par le fait que les collecteurs (12,22) du magnétotransistor (3) forment simultanément la base des transistors de commutation (14,24) qui leur sont associés.

5.  Capteur de champ magnétique suivant la revendication 4, caractérisé par le fait que les transistors de commutation (14,24) associés à un magnétotransistor possèdent un émetteur commun, qui constitue simultanément la base (34) du magnétotransistor (3).

6.  Capteur de champ magnétique suivant l'une des revendications 1 à 5, caractérisé par le fait que le magnétotransistor (3) est constitué sous la forme d'un transistor latéral et que les transistors de commutation (14,24) sont réalisés sous la forme de transistors verticaux.

7.  Capteur de champ magnétique suivant l'une des revendications 1 à 6, caractérisé par les particularités suivantes :

    a) les collecteurs (12,22) du magnétotransistor (3) sont disposés symétriquement par rapport à un plan de symétrie, perpendiculaire à la surface du semiconducteur, de 1'émetteur (32) du magnétotransistor (3),

    b) 1'émetteur (32) est disposé entre les collecteurs (12,22).

8.  Capteur de champ magnétique suivant l'une des revendications 1 à 7, caractérisé par le fait que l'émetteur (32) du magnétotransistor (3) comporte au moins une zone (38) possédant un dopage inverse.

9. Capteur de champ magnétique suivant l'une des revendications 1 à 8, caractérisé par le fait que de l'arseniure de gallium est prévu en tant que substrat semiconducteur.

10. Capteur de champ magnétique suivant l'une des revendications 1 à 8, caractérisé par le fait que du silicium est prévu en tant que substrat semiconducteur.

11. Capteur de champ magnétique suivant la revendication 10, caractérisé par le fait que les inverseurs, qui font partie des différents magnétotransistors (3) sont séparés les uns des autres par une paroi d'oxyde (40).

FIG 1

FIG 2

FIG 3

10

FIG 4

FIG 5